# EUROPÄISCHE PATENTSCHRIFT

(11) **EP 3 574 726 B1**
(45) Veröffentlichungstag und Bekanntmachung des Hinweises auf die Patenterteilung: **17.11.2021**
(21) Anmeldenummer: 18701441.0
(22) Anmeldetag: 22.01.2018
(51) Int. Cl.: H05K 7/20, B25J 19/00

(54) **KÜHLVORRICHTUNG UND ROBOTERSTEUERVORRICHTUNG MIT EINER SOLCHEN KÜHLVORRICHTUNG**
COOLING DEVICE AND ROBOT CONTROL DEVICE HAVING A COOLING DEVICE OF THIS KIND
DISPOSITIF DE REFROIDISSEMENT ET DISPOSITIF DE COMMANDE DE ROBOT ÉQUIPÉ D'UN TEL DISPOSITIF DE REFROIDISSEMENT

(30) Priorität: 30.01.2017 DE 102017201410
(43) Veröffentlichungstag der Anmeldung: 04.12.2019
(73) Patentinhaber: KUKA Deutschland GmbH, 86165 Augsburg (DE)
(72) Erfinder: WAGNER, Michael, 86836 Untermeitingen (DE); WERNER, Gerhard, 88471 Laupheim (DE); SELIC, Mario, 86159 Augsburg (DE)
(74) Vertreter: Oelke, Jochen
(86) Internationale Anmeldenummer: PCT/EP2018/051419
(87) Internationale Veröffentlichungsnummer: WO 2018/138041

(56) Entgegenhaltungen:
- EP-A1- 2 879 475
- EP-A2- 2 797 396
- DE-U1-202008 012 988
- US-A- 5 424 915
- US-A1- 2012 050 990

## Beschreibung

Die Erfindung betrifft eine Kühlvorrichtung zum Kühlen von elektrischen Komponenten einer Robotersteuervorrichtung mittels einer durch einen Lüfter erzeugten Kühlluftströmung. Die Erfindung betrifft außerdem eine Robotersteuervorrichtung mit einer solchen Kühlvorrichtung.

Aus der DE 10 2008 062 430 A1 ist ein Steuerschrank, insbesondere für Industrieroboter bekannt, aufweisend einen Aufnahmeraum für ein Baugruppen-Gehäuse, sowie weitere Steuerbauelemente und/oder Steuerbaugruppen, einen Lüftungsraum, eine den Aufnahmeraum vom Lüftungsraum trennende Zwischenwand, einen im Lüftungsraum angeordneten Wärmetauscher, dessen erste Kühlstrukturen dem Innenkreislauf des Aufnahmeraums zugeordnet und dessen zweite Kühlstrukturen dem Außenkreislauf des Lüftungsraums zugeordnet sind, wobei eine Innenkreislauf-Luftströmung von einem in einem Baugruppen-Gehäuse, insbesondere Steuerrechner-Gehäuse integrierten Lüfter erzeugt wird.

Die US 5,424,915 beschreibt ein Netzteil, das einerseits Halbleiterbauteile umfasst, die Wärme erzeugen, und andererseits Bauelemente umfasst, die keine wesentliche Wärme entwickeln. Das Gehäuse des Netzteils ist in zwei Abteile unterteilt in denen die Halbleiterbauteile und die Bauelemente untergebracht sind, wobei zwischen den beiden Abteilen ein Luftströmungskanal angeordnet ist.

Aus der EP 2 879 475 A1 ist ein Solarwechselrichter bekannt, welcher ein Gehäuse aufweist, das wenigstens einen Luftkanal aufweist, durch den Luft mittels eines Ventilators angezogen wird.

Aus der EP 2 797 396 A2 ist ein Steuerschrank bekannt, der ein Gehäuse aufweist, in dem wenigstens eine elektrische Komponente angeordnet ist. Innerhalb des Gehäuses sind ein elektrischer Motor und ein Energiespeicher vorgesehen, wobei der Motor ein Schwungrad antreibt, welches einen Luftstrom zum Kühlen der wenigstens einen elektrischen Komponente erzeugt.

Aus der DE 20 2008 012 988 U1 ist eine Kühlanordnung einer Leistungselektronikvorrichtung bekannt. Die Kühlanordnung weist einen Kühllüfter auf, der in einem Modul angeordnet ist, wobei das Modul so angeordnet ist, dass zumindest ein Teil der zu kühlenden Komponenten in dem Kühlluftkanal auf der Eingangsseite des Lüfters angeordnet sind.

Aufgabe der Erfindung ist es, eine Kühlvorrichtung zum Kühlen von elektrischen Komponenten einer Robotersteuervorrichtung, und eine Robotersteuervorrichtung mit einer solchen Kühlvorrichtung zu schaffen, die eine besonders effektive Wärmeabführung von elektrischen Komponenten einer Robotersteuervorrichtung auf kompakte Weise ermöglicht.

Diese Aufgabe wird erfindungsgemäß gelöst durch eine Kühlvorrichtung zum Kühlen von elektrischen Komponenten einer Robotersteuervorrichtung mittels einer durch einen Lüfter erzeugten Kühlluftströmung, aufweisend einen ersten Aufnahmeraum für erste elektrische Komponenten, einen zweiten Aufnahmeraum für zweite elektrische Komponenten und eine den ersten Aufnahmeraum strömungstechnisch von dem zweiten Aufnahmeraum separierende Kühlkörperwand, welche eine dem ersten Aufnahmeraum zugewandte erste Trennwandoberfläche und eine gegenüberliegende, einem Zwischenraum der Kühlkörperwand zugewandte zweite Trennwandoberfläche aufweist, die mit wenigstens einen Strömungskanal bildenden Kühlwandvorsprüngen versehen ist, und welche Kühlkörperwand eine Kühlluft-Durchtrittsöffnung aufweist, die ausgebildet ist, einen von wenigstens einem Lüfter der Kühlvorrichtung geförderten Kühlluftstrom aus dem ersten Aufnahmeraum durch die Kühlkörperwand hindurch in den Zwischenraum zu fördern, wobei die Kühlluft-Durchtrittsöffnung im Bereich eines ersten Endabschnitts der Kühlkörperwand angeordnet ist, die Kühlwandvorsprünge wenigstens einen ersten Strömungskanal bilden, der einen von der Kühlluft-Durchtrittsöffnung ausgehenden, zu einen dem ersten Endabschnitt der Kühlkörperwand gegenüberliegenden zweiten Endabschnitt der Kühlkörperwand hinführenden ersten Hinströmungskanalabschnitt und einen von dem zweiten Endabschnitt der Kühlkörperwand ausgehenden, zu dem ersten Endabschnitt der Kühlkörperwand zurückführenden ersten Rückströmungskanalabschnitt aufweist, an welchem ersten Endabschnitt eine erste Ausblasöffnung angeordnet ist, über welche die Kühlluft aus dem Zwischenraum austritt.

Eine erfindungsgemäße Kühlvorrichtung umfasst jedenfalls wenigstens einen Lüfter, der eine Fördervorrichtung bildet, um Luft in Bewegung zu setzen und einen Kühlkörper, der ausgebildet ist, die in einem elektrischen oder elektronischen Bauteil einer elektrischen oder elektronischen Komponente insbesondere als Verlustenergie erzeugte Wärme durch Wärmeleitung von dem Bauteil wegzuführen, in dem Kühlkörper aufzunehmen und innerhalb des Kühlkörpers, der aus einem Material hergestellt ist, das gute Wärmeleiteigenschaften aufweist, durch Wärmeleitung zu verteilen, sowie Kühlwandvorsprünge, die insbesondere einteilig mit dem Kühlkörper hergestellt sind, und die ausgebildet sind, die von dem Bauteil in den Kühlköper aufgenommene Wärme an die Umgebung, d.h. an die Luft insbesondere durch Konvektion wieder abzugeben.

Die elektrischen Komponenten können elektrische und/oder elektronische Komponenten sein. Die jeweilige Komponente kann insbesondere elektronische Halbleiterbauelemente aufweisen, die beispielsweise Leistungshalbleiter sein können, wie beispielsweise Leistungsdioden, Thyristoren, Triacs, oder Leistungs-MOSFETs und IGBT-Bauteile, oder ähnliche Leistungstransistoren. Das elektronische Halbleiterbauelement kann aber auch ein Mikroprozessor, wie beispielsweise eine CPU oder ein Grafikprozessor eines Digitalrechners sein. Die elektrische und/oder elektronische Komponente selbst kann beispielsweise ein Antriebsverstärker oder eine elektronische Platine sein.

Der jeweilige Aufnahmeraum bildet innerhalb eines Gehäuses einen Platz, in dem die jeweils benötigten elektrischen und/oder elektronischen Komponenten angeordnet sind.

So kann beispielsweise der erste Aufnahmeraum dazu vorgesehen sein, die elektrischen und/oder elektronischen Komponenten aufzunehmen, welche vorgesehen sind, die Motoren eines Roboterarms zum Bewegen der Gelenke des Roboterarms mit elektrischen Energie zu versorgen und die Motoren damit anzusteuern, so dass die Gelenke des Roboterarms automatisch gemäß eines Roboterprogramms oder in einem Handfahrbetrieb manuell angesteuert bewegt werden können. So kann der erste Aufnahmeraum einen Niederspannungsbereich für die Leistungselektronik bilden.

Der zweite Aufnahmeraum kann dazu vorgesehen sein, die elektrischen und/oder elektronischen Komponenten aufzunehmen, welche vorgesehen sind, die Steuerungs-Hardware der Robotersteuerung zu bilden. Demgemäß kann der zweite Aufnahmeraum beispielsweise eine Hauptplatine (Motherboards) eines Computers bilden, auf dem die Steuerungssoftware des Roboters ausführbar ist. So kann der zweite Aufnahmeraum einen Schutzkleinspannungsbereich für die Steuerelektronik bilden.

Die Kühlkörperwand ist aus einem Material hergestellt, das gute, insbesondere sehr gute Wärmeleiteigenschaften aufweist, so dass die in die Kühlkörperwand eingebrachte Wärme durch Wärmeleitung möglichst schnell verteilt und an die Kühlwandvorsprünge transportiert werden kann, so dass die Kühlwandvorsprünge die Wärme an die Umgebung, d.h. an die Luft abgeben können. Die Kühlkörperwand bildet somit einen speziellen Kühlkörper, der einerseits alle wesentlichen Eigenschaften bekannter Kühlkörper aufweist und somit aus gut wärmeleitendem Material besteht, eine möglichst große Oberfläche aufweist und aufgrund der Anordnung von Kühlwandvorsprüngen eine Konvektionsluftströmung begünstigt bzw. fördert, und andererseits eine mechanische Trennwand oder Barriere bildet, um den ersten Aufnahmeraum zumindest strömungstechnisch von dem zweiten Aufnahmeraum zu trennen. Die Kühlkörperwand kann beispielsweise außerdem ausgebildet sein, den ersten Aufnahmeraum von dem zweiten Aufnahmeraum elektrisch zu trennen. Die Kühlkörperwand kann demgemäß bevorzugt aus den bekannten Materialien Aluminium oder Kupfer hergestellt sein. Es sind jedoch auch andere Materialien, wie beispielsweise Legierungen denkbar, die entsprechend hohe Wärmeleitfähigkeiten aufweisen, wie Aluminium oder Kupfer. Die Legierungen können beispielsweise auch Aluminium und/oder Kupfer aufweisen.

Aufgrund der erfindungsgemäßen Eigenschaft, dass die Kühlkörperwand neben dem Effekt der Wärmeleitung außerdem eine (mechanische) Trennwand bildet, die den ersten Aufnahmeraum von dem zweiten Aufnahmeraum trennt, weist die Kühlkörperwand eine dem ersten Aufnahmeraum zugewandte erste Trennwandoberfläche auf und eine dem zweiten Aufnahmeraum zugewandte zweite Trennwandoberfläche auf. Die Kühlkörperwand trennt den ersten Aufnahmeraum von dem zweiten Aufnahmeraum zumindest strömungstechnisch. Dies bedeutet, dass eine im ersten Aufnahmeraum beispielsweise durch Konvektion auftretende Luftströmung (passive Luftströmung) oder durch einen Lüfter erzwungene Luftströmung (aktive Luftströmung) zumindest weitgehend oder vollständig unbeeinflusst stattfinden kann, von einer im zweiten Aufnahmeraum beispielsweise durch Konvektion auftretende Luftströmung (passive Luftströmung) oder durch einen Lüfter erzwungene Luftströmung (aktive Luftströmung). Die Kühlkörperwand kann den ersten Aufnahmeraum somit beispielsweise luftdicht von dem zweiten Aufnahmeraum trennen. Eine ausreichende strömungstechnische Trennung ist jedoch schon dann gegeben, wenn die Kühlkörperwand den ersten Aufnahmeraum zwar nicht absolut luftdicht von dem zweiten Aufnahmeraum trennen, aber nur derart geringe Luftspalte oder Durchtritte vorhanden sind, die zwar eine Leckageluftströmung zulassen, die aber so gering ist, dass die jeweils in dem ersten Aufnahmeraum oder zweiten Aufnahmeraum gewünschte Luftströmungsweise nicht wesentlich gestört oder verändert ist.

Die Kühlwandvorsprünge dienen dazu, die Oberfläche der Kühlkörperwand zu vergrößern, um eine bessere Wärmeabgabe an die Luft der Umgebung zu erreichen. Die Kühlwandvorsprünge können in einer ersten allgemeinen Ausführungsform von flächigen, sich insbesondere senkrecht von der Kühlkörperwand erhebenden, d.h. vorspringenden Kühlrippen gebildet werden. Die Kühlrippen können dabei außerdem zusätzliche Kanalwände des wenigstens einen Strömungskanals bilden. In einer zweiten allgemeinen Ausführungsform können die Kühlwandvorsprünge aber auch lediglich von einer Mehrzahl von sich insbesondere senkrecht von der Kühlkörperwand erhebenden, d.h. vorspringenden und voneinander beabstandeten Kühldomen, Kühlfingern oder Kühlzapfen gebildet werden. Die Kühlwandvorsprünge beider Ausführungsformen können an der Kühlkörperwand derart angeordnet sein, dass jeweils zwei benachbarte Kühlrippen oder jeweils zwei benachbarte Reihen von Kühldomen, Kühlfingern oder Kühlzapfen einen Strömungskanal für Luft bilden.

Der erfindungsgemäße Zwischenraum wird durch die von den Kühlwandvorsprüngen begrenzten Strömungskanäle gebildet. Der Zwischenraum ist insoweit an der Kühlkörperwand ausgebildet. Der Zwischenraum liegt demgemäß separierend zwischen dem ersten Aufnahmeraum und dem zweiten Aufnahmeraum.

Mittels der erfindungsgemäßen Kühlkörperwand wird eine Kühlvorrichtung geschaffen, bei der erste elektrische Komponenten und zweite elektrische Komponenten in separierten Aufnahmeräumen getrennt voneinander angeordnet sind und die Kühlkörperwand dabei eine Trennwand bildet, welche die separierten Komponenten zumindest strömungstechnisch voneinander trennt. Weitere trennende Eigenschaften können durch die erfindungsgemäße Kühlkörperwand erreicht werden, insbesondere ein elektrische Trennung, insbesondere in einen Niederspannungsbereich für die Leistungselektronik und einen Schutzkleinspannungsbereich für die Steuerelektronik, aber beispielsweise auch eine Trennung hinsichtlich elektro-magnetischer Verträglichkeit (EMV) oder Geräuschen.

Die Kühlvorrichtung kann einen ersten Lüfter aufweisen, der an der Kühlluft-Durchtrittsöffnung angeordnet ist und derart ausgebildet ist, dass der erste Lüfter die Kühlluft aus dem ersten Aufnahmeraum ansaugt und in den Zwischenraum ausstößt.

Der erste Lüfter kann als ein erster Radiallüfter ausgebildet sein, der derart angeordnet ist, dass der erste Radiallüfter die Kühlluft aus dem ersten Aufnahmeraum in axialer Richtung ansaugt und in radialer Richtung in den Zwischenraum ausstößt.

Der erste Lüfter, insbesondere der erste Radiallüfter kann wenigstens ein Lüfterrad und einen das Lüfterrad antreibenden elektrischen Motor umfassen.

Die Kühlluft-Durchtrittsöffnung ist erfindungsgemäß im Bereich eines ersten Endabschnitts der Kühlkörperwand angeordnet, die Kühlwandvorsprünge bilden dabei wenigstens einen ersten Strömungskanal, der einen von der Kühlluft-Durchtrittsöffnung ausgehenden, zu einen dem ersten Endabschnitt der Kühlkörperwand gegenüberliegenden zweiten Endabschnitt der Kühlkörperwand hinführenden ersten Hinströmungskanalabschnitt und einen von dem zweiten Endabschnitt der Kühlkörperwand ausgehenden, zu dem ersten Endabschnitt der Kühlkörperwand zurückführenden ersten Rückströmungskanalabschnitt aufweist, an welchem ersten Endabschnitt eine erste Ausblasöffnung angeordnet ist, über welche die Kühlluft aus dem Zwischenraum austritt.

An die Kühlluft-Durchtrittsöffnung schließt sich in Strömrungsrichtung demgemäß ein erster Strömungskanal an oder es schließen sich mehrere erste Strömungskanäle an, von denen jeder Strömungskanal einen Hinströmungskanalabschnitt aufweist, der die Luft insoweit über eine zumindest annähernd vollständige Breite oder vollständige Höhe der Kühlkörperwand in einer Richtung leitet, wobei der jeweilige Strömungskanal am Ende des Hinströmungskanalabschnitts einen Umlenkströmungskanalabschnitt aufweist, der beispielsweise U-förmig gestaltet sein kann, der ausgebildet ist die Luft aus dem Ende des Hinströmungskanalabschnitts in den Anfang des Rückströmungskanalabschnitts zu leiten. Der Rückströmungskanalabschnitt wiederum leitet die Luft über die zumindest annähernd vollständige Breite oder vollständige Höhe der Kühlkörperwand in entgegengesetzter Richtung zurück, wo die Luft somit die Breite bzw. die Höhe der Kühlkörperwand zweimal passiert hat (einmal über den Hinströmungskanalabschnitt und einmal über den Rückströmungskanalabschnitt) und anschließend in Strömungsrichtung aus dem Zwischenraum austritt. Zwei oder mehrere Strömungskanäle können parallel zueinander angeordnet sein. Eine gemeinsame Kühlrippe kann eine gemeinsame Seitenwand zweier benachbarter Strömungskanäle sein. Jeder Strömungskanal kann in einer U-Form gestaltet sein. Mehrere U-förmige Strömungskanäle können ineinander geschachtelt angeordnet sein, so dass die mehreren U-förmige Strömungskanäle parallel zueinander angeordnet sind.

Die Kühlvorrichtung kann generell einen mit der Kühlkörperwand verbundenen, auf der Seite der zweiten Trennwandoberfläche der Kühlkörperwand angeordneten ersten Deckel aufweisen, der ausgebildet ist, die den wenigstens einen Strömungskanal bildenden Kühlwandvorsprüngen zu überdecken, derart, dass der wenigstens eine Strömungskanal sowohl von der zweiten Trennwandoberfläche, als auch von den Kühlwandvorsprüngen und dem ersten Deckel strömungstechnisch begrenzend eingefasst ist.

Der Deckel kann an der Kühlkörperwand und/oder an den Kühlwandvorsprüngen somit beispielsweise luftdicht angebracht sein. Eine ausreichende strömungstechnische Trennung ist jedoch schon dann gegeben, wenn der Deckel zwar nicht absolut luftdicht an der Kühlkörperwand und/oder an den Kühlwandvorsprüngen anliegt, aber nur derart geringe Luftspalte oder Durchtritte vorhanden sind, die zwar eine Leckageluftströmung zulassen, die aber so gering ist, dass die jeweils in den Strömungskanälen gewünschten Luftströmungsweisen nicht wesentlich gestört oder verändert ist.

Der erste Deckel kann eine Aussparung aufweisen, die ausgebildet ist, einen von wenigstens einem Lüfter der Kühlvorrichtung geförderten Kühlluftstrom aus dem zweiten Aufnahmeraum über den ersten Deckel hinweg in den Zwischenraum zu fördern.

Die Aussparung kann eine randoffene Aussparung an einem Randabschnitt des Deckels sein. Alternativ kann die Aussparung aber auch als ein konturgeschlossenes Fenster oder ein randfernes Loch in dem Deckel ausgebildet sein.

Die Kühlvorrichtung kann einen zweiten Lüfter aufweisen, der im Bereich der Aussparung des ersten Deckels angeordnet ist und derart ausgebildet ist, dass der zweite Lüfter die Kühlluft aus dem zweiten Aufnahmeraum ansaugt und in den Zwischenraum ausstößt.

Der zweite Lüfter kann als ein zweiter Radiallüfter ausgebildet sein, der derart angeordnet ist, dass der zweite Radiallüfter die Kühlluft aus dem zweiten Aufnahmeraum in axialer Richtung ansaugt und in radialer Richtung in den Zwischenraum ausstößt.

Der zweite Lüfter, insbesondere der zweite Radiallüfter kann wenigstens ein Lüfterrad und einen das Lüfterrad antreibenden elektrischen Motor umfassen.

Die Aussparung des ersten Deckels kann im Bereich des ersten Endabschnitts der Kühlkörperwand angeordnet sein, die Kühlwandvorsprünge wenigstens einen zweiten Strömungskanal bilden, der einen von der Aussparung des ersten Deckels ausgehenden, zu einen dem ersten Endabschnitt der Kühlkörperwand gegenüberliegenden zweiten Endabschnitt der Kühlkörperwand hinführenden zweiten Hinströmungskanalabschnitt und einen von dem zweiten Endabschnitt der Kühlkörperwand ausgehenden, zu dem ersten Endabschnitt der Kühlkörperwand zurückführenden zweiten Rückströmungskanalabschnitt aufweisen, an welchem ersten Endabschnitt eine zweite Ausblasöffnung angeordnet ist, über welche die Kühlluft aus dem Zwischenraum austritt.

An die Aussparung schließt sich in Strömrungsrichtung demgemäß ein zweiter Strömungskanal an oder es schließen sich mehrere zweite Strömungskanäle an, von denen jeder Strömungskanal einen Hinströmungskanalabschnitt aufweist, der die Luft insoweit über eine zumindest annähernd vollständige Breite oder vollständige Höhe der Kühlkörperwand in einer Richtung leitet, wobei der jeweilige Strömungskanal am Ende des Hinströmungskanalabschnitts einen Umlenkströmungskanalabschnitt aufweist, der beispielsweise U-förmig gestaltet sein kann, der ausgebildet ist die Luft aus dem Ende des Hinströmungskanalabschnitts in den Anfang des Rückströmungskanalabschnitts zu leiten. Der Rückströmungskanalabschnitt wiederum leitet die Luft über die zumindest annähernd vollständige Breite oder vollständige Höhe der Kühlkörperwand in entgegengesetzter Richtung zurück, wo die Luft somit die Breite bzw. die Höhe der Kühlkörperwand zweimal passiert hat (einmal über den Hinströmungskanalabschnitt und einmal über den Rückströmungskanalabschnitt) und anschließend in Strömungsrichtung aus dem Zwischenraum austritt. Zwei oder mehrere Strömungskanäle können parallel zueinander angeordnet sein. Eine gemeinsame Kühlrippe kann eine gemeinsame Seitenwand zweier benachbarter Strömungskanäle sein. Jeder Strömungskanal kann in einer U-Form gestaltet sein. Mehrere U-förmige Strömungskanäle können ineinander geschachtelt angeordnet sein, so dass die mehreren U-förmige Strömungskanäle parallel zueinander angeordnet sind.

Die zweiten Strömungskanäle können an der Kühlkörperwand insbesondere spiegelsymmetrisch zu den ersten Strömungskanälen angeordnet sein.

Die dem ersten Aufnahmeraum zugewandte erste Trennwandoberfläche der Kühlkörperwand kann Befestigungsdome aufweisen, die zur Befestigung wenigstens einer elektrischen Komponente ausgebildet sind, welche elektrische Komponente zumindest ein Leistungshalbleiterbauelement aufweist, wobei die Befestigungsdome derart ausgebildet sind, dass im befestigten Zustand der elektrischen Komponente das mindestens eine Leistungshalbleiterbauelement Wärme übertragend an der ersten Trennwandoberfläche der Kühlkörperwand anliegt.

Die Kühlkörperwand kann in allen Ausführungen als ein einteiliger Druckgusskühlkörper ausgebildet sein. Die Kühlkörperwand ist dabei aus einem Material hergestellt, das gute, insbesondere sehr gute Wärmeleiteigenschaften aufweist, so dass die in die Kühlkörperwand eingebrachte Wärme durch Wärmeleitung möglichst schnell verteilt und an die Kühlwandvorsprünge transportiert werden kann, so dass die Kühlwandvorsprünge die Wärme an die Umgebung, d.h. an die Luft abgeben können. Die Kühlkörperwand bildet somit einen speziellen Kühlkörper, der einerseits alle wesentlichen Eigenschaften bekannter Kühlkörper aufweist und somit aus gut wärmeleitendem Material besteht, eine möglichst große Oberfläche aufweist und aufgrund der Anordnung von Kühlwandvorsprüngen eine Konvektionsluftströmung begünstigt bzw. fördert, und andererseits eine mechanische Trennwand oder Barriere bildet, um den ersten Aufnahmeraum zumindest strömungstechnisch von dem zweiten Aufnahmeraum zu trennen. Die Kühlkörperwand kann beispielsweise außerdem ausgebildet sein, den ersten Aufnahmeraum von dem zweiten Aufnahmeraum elektrisch zu trennen. Die Kühlkörperwand kann demgemäß bevorzugt aus den bekannten Materialien Aluminium oder Kupfer hergestellt sein. Es sind jedoch auch andere Materialien, wie beispielsweise Legierungen denkbar, die entsprechend hohe Wärmeleitfähigkeiten aufweisen, wie Aluminium oder Kupfer. Die Legierungen können beispielsweise auch Aluminium und/oder Kupfer aufweisen.

Die Kühlkörperwand kann zusammen mit der eine Gehäuseaußenwand eines Gehäuses einer Robotersteuervorrichtung bildenden, umlaufenden Begrenzungsseitenwand als ein einteiliger Druckgusskühlkörper ausgebildet sein, wie im vorherigen Absatz beschrieben.

Die Kühlkörperwand kann demgemäß in allen Ausführungen eine rahmenartig die Kühlkörperwand einfassende, umlaufende Begrenzungsseitenwand aufweisen, die sich zumindest im Wesentlichen senkrecht zur Ebene der Kühlkörperwand erstreckt und die ausgebildet ist, eine Gehäuseaußenwand eines Gehäuses einer Robotersteuervorrichtung zu bilden.

Die umlaufende Begrenzungsseitenwand der Kühlkörperwand kann demgemäß vier Seitenwände eines Gehäuses der Robotersteuervorrichtung bilden. Darüber hinaus können die verbleibenden zwei Seiten des Gehäuses, die insbesondere eine Vorderseite und eine Rückseite des Gehäuses bilden, durch jeweils einem separaten Gehäusedeckel verschlossen sein. Jeder Gehäusedeckel kann mittels lösbarer Befestigungsmittel unmittelbar an der Kühlkörperwand befestigt, beispielsweise angeschraubt sein. Dazu kann die Kühlkörperwand entsprechende Gewindebohrungen aufweisen, in welche Schrauben einschraubbar sind, welche den separaten Gehäusedeckel an der Kühlkörperwand lösbar befestigen, um zusammen mit der umlaufenden Begrenzungsseitenwand, die vorzugsweise einteilig mit der Kühlkörperwand ausgebildet ist, ein vollständig geschlossenes Gehäuses der Robotersteuervorrichtung zu bilden.

Die erfindungsgemäße Aufgabe wird außerdem gelöst, durch eine Robotersteuervorrichtung, die eine Kühlvorrichtung nach einem oder mehreren der beschriebenen Ausführungen aufweist.

In einer Robotersteuervorrichtung gilt es nicht nur die Leistungselektronik, wie insbesondere die Leistungselektronik von Antriebsverstärker für die Motoren des Roboters, sondern auch die restlichen elektronischen Komponente, wie insbesondere allgemeine Steuerungsplatinen, wie bspw. PC-Boards, zu kühlen. Dies kann zwar durch die Verwendung von getrennten Kühlsystemen realisiert werden, um allerdings bspw. Platz und Kosten zu sparen, kann eine kombinierte Lösung zur Kühlung der gesamten Robotersteuervorrichtung vorteilhaft sein. Zudem kann der Aufbau des Gehäuses der Robotersteuervorrichtung, sowie die elektrische und/oder mechanische Verbindung der einzelnen elektronischen Komponente, wie bspw. Leiterplatten, in der Robotersteuervorrichtung möglichst kosteneffizient und zeiteffizient in der Montage gestaltet werden.

Mit der erfindungsgemäßen Kühlvorrichtung kann eine Kühlung der am Kühlkörper, d.h. an der Kühlkörperwand montierten Leistungsmodule, insbesondere der Antriebsverstärker, wie folgt erfolgen.

Um eine platzsparende Kühlmöglichkeit zu erhalten, wird ein Kühlkörper, d.h. eine Kühlkörperwand vorgeschlagen, welcher durch beispielsweise zwei innenliegende Radiallüfter mit Luft durchströmt wird. Dabei kann einer der beiden Lüfter um 180 Grad gewendet montiert sein, so dass die Ansaugöffnung zum Kühlkörper zeigt. An dieser Ansaugstelle kann ein insbesondere rundes Loch am Kühlkörper, d.h. an der Kühlkörperwand ausgespart sein. Dies ermöglicht ein Ansaugen der Luft von beiden Seiten des Kühlkörpers. Die eingebauten Radiallüfter ermöglichen durch ihre insbesondere flache Bauform in Luftaustrittsrichtung, sowie der Eigenschaft hohe Druckunterschiede erzeugen zu können, ein flaches Design des Kühlkörpers. Um den Luftstrom an den Kühlwandvorsprüngen des Kühlkörpers entlang zu führen, kann beispielsweise ein Blech oder Deckel auf der Seite der Kühlwandvorsprünge montiert sein. Der Luftstrom kann im Kühlkörper so geleitet werden, dass dieser an einem Endabschnitt des Kühlkörpers bzw. der Kühlkörperwand, wie beispielsweise einer Oberseite des Kühlkörpers austritt. Dadurch wird ein definierter Luftstrom an jeder Stelle des Kühlkörpers gewährleistet.

Mit der erfindungsgemäßen Kühlvorrichtung kann eine Befestigung der Komponenten an der Kühlkörperwand wie folgt erfolgen.

Ein Blech, d.h. ein Deckel zur Sicherstellung der Luftführung durch die von den Kühlwandvorsprüngen begrenzten Kühlkanäle, kann direkt auf den Kühlkörper bzw. unmittelbar über dem Kühlkörper, d.h. der Kühlkörperwand montiert werden. Zusätzliche Haltedome, die beispielsweise im Falle einer im Druckgussverfahren aus Aluminium hergestellten Kühlkörperwand, auch direkt an die Kühlkörperwand angeformt sein können, dienen der Befestigung der elektrischen und/oder elektronischen Komponenten, wie beispielsweise die Elektronikkomponenten im Schutzkleinspannungsbereich.

Beispielsweise die Leistungsmodule der Umrichter oder der Antriebsverstärker, werden auf der gegenüberliegenden Seite des Kühlkörpers, d.h. der Kühlkörperwand direkt angeschraubt. Dadurch kann die Hauptverlustleistung der Robotersteuervorrichtung direkt in die luftdurchströmten Kühlkörperwand eingetragen werden. Aluminium-Dome, welche durch das Druckgussverfahren an den Kühlkörper angeformt sein können, können als Anschraubpunkte beispielsweise für eine Umrichterplatine dienen. Weitere Komponenten, welche beispielsweise für die Ansteuerung der Leistungshalbleiter nötig sind, können über Abstandsbolzen und (Board-to-Board)-Steckverbindern direkt mit der Umrichterplatine verbunden werden. Eine solche Aufteilung der Komponenten auf den beiden Seiten des Kühlkörpers, d.h. der Kühlkörperwand, sorgt nicht nur für eine insgesamt schlanke und stabile Befestigung der Komponenten, sondern auch für die räumliche Trennung der insbesondere einen Niederspannungsbereich bildenden Leistungselektronik und der insbesondere einen Schutzkleinspannungsbereich bildenden Steuerelektronik. Somit übernimmt der Kühlkörper, d.h. der Kühlkörperwand nicht nur die Funktion der Kühlung, sondern auch einen elektrischen Berührschutz zwischen dem Niederspannungsbereich der Umrichter und dem Schutzkleinspannungsbereich des Steuerungs-PCs, sowie der Abschirmung des Steuerungs-PCs vor elektrischen und magnetischen Feldern aus dem Leistungsteil.

Mit der erfindungsgemäßen Kühlvorrichtung kann ergänzend auch eine Kühlung der sonstigen, nicht am Kühlkörper montierten elektrischen Komponenten, wie folgt erfolgen.

Zusätzlich zum schmalen Kühlkörperdesign wird es möglich, insbesondere durch die Verwendung von Radiallüftern, auch diejenigen elektrischen oder elektronischen Komponenten zu kühlen, welche nicht wie die Leistungsmodule zur Wärmeübertragung mit dem Kühlkörper in Kontakt sind. Hierfür wird zu dem ersten Aufnahmeraum, der die Umrichter enthält, eine Aussparung entsprechend der Ansaugöffnung des Radiallüfters in den Kühlkörper gefräst. Zusätzlich können in einem Steckerfeld, das beispielsweise an einer Unterseite des Gehäuses der Robotersteuervorrichtung angeordnet ist, Lüftungsschlitze als ein Frischlufteintritt eingebracht sein. Die Lüftungsschlitze ermöglichen eine Luftströmung vom Steckerfeld an der Unterseite der Robotersteuervorrichtung über die Komponenten in dem ersten Aufnahmeraum hinweg zum Radiallüfter hin. Dadurch können diese Komponenten mit kalter Frischluft gekühlt werden. Die dann vorgewärmte Luft wird anschließend durch den Kühlkörper, d.h. die Kühlkörperwand hindurchgeleitet und tritt an der dem Steckerfeld des Frischlufteintritts gegenüberliegenden Seite aus dem Gehäuse, d.h. aus der Robotersteuervorrichtung wieder ins Freie aus. Der Frischlufteintritt kann insbesondere an einer Unterseite des Gehäuses der Robotersteuervorrichtung ausgebildet sein und der Austritt kann an der gegenüberliegenden Oberseite ausgebildet sein. Dies ist vorteilhaft, da diese Anordnung der natürlichen Konvektion entspricht, welche in Schaltschränken, Steuerungsschränken und PC-Gehäusen in denen die Robotersteuerung verbaut sein kann, nicht gehemmt werden soll. Die Kühlung des Steuerungs-PC-Teils funktioniert dann in identischer Weise durch einen zweiten Radiallüfter, welcher die Luft von der gegenüberliegenden Seite des Kühlkörpers ansaugt.

Ein weiterer Vorteil dieses Kühlkonzeptes mit innenliegendem Kühlkörper, d.h. innenliegender Kühlkörperwand ist ein stark verringertes Gewicht, durch einen schmalen und doppelseitigen Aufbau.

Bei einer Herstellung der erfindungsgemäßen Kühlvorrichtung im Druckgussverfahren, insbesondere im Aluminium-Druckgussverfahren, ist es zweckmäßig in Ausformungsrichtung einen Ausformungswinkel bspw. von ca. 1,5° vorzusehen. Dieser Winkel ist nötig, um im Druckprozess das Ausformungswerkzeug nach dem Erstarren des Gusses, insbesondere des Aluminiums ohne Probleme nach außen ziehen zu können. Dies bedeutet, dass die Wandstärke des Druckgusses mit der Höhe in Ausformungsrichtung zunimmt. Somit wirkt sich eine Erhöhung des Gehäuses in Ausformungsrichtung nicht nur linear, sondern quadratisch auf das Gewicht des Gehäuses aus. Hier wirkt sich das schlanke Kühlwandvorsprünge-Design besonders positiv auf die Kosten und das Gewicht des Gehäuses aus. Zudem wird durch die innenliegenden Kühlkörperflächen eine nahezu symmetrische Ausformung gewährleistet. Die Wandstärke am dicksten Punkt kann dadurch deutlich reduziert werden.

Ein konkretes Ausführungsbeispiel der Erfindung ist in der nachfolgenden Figurenbeschreibung unter Bezugnahme auf die beigefügten Figuren näher erläutert. Konkrete Merkmale dieses exemplarischen Ausführungsbeispiels können unabhängig davon, in welchem konkreten Zusammenhang sie erwähnt sind, gegebenenfalls auch einzeln oder auch in anderen Kombinationen der Merkmale betrachtet, allgemeine Merkmale der Erfindung darstellen.

Es zeigen:
- Fig. 1: eine perspektivische Darstellung eines beispielhaften Industrieroboters in Art eines Sechsachs-Knickarmroboters, der eine erfindungsgemäße Robotersteuervorrichtung aufweist;
- Fig. 2: eine perspektivische Darstellung eines konkreten Ausführungsbeispiels einer erfindungsgemäßen Kühlvorrichtung in einer Ansicht auf den ersten Aufnahmeraum zur Aufnahme wenigstens einer elektrischen Komponente, die mindestens ein wärmeerzeugendes Leistungshalbleiterbauelement aufweist;
- Fig. 3: eine perspektivische Darstellung der Kühlvorrichtung gemäß Fig. 2 in einer Ansicht auf den Zwischenraum, bei entferntem ersten Deckel;
- Fig. 4: eine perspektivische Darstellung der Kühlvorrichtung gemäß Fig. 2 in einer Ansicht auf den zweiten Aufnahmeraum, bei angebrachtem ersten Deckel, derart, dass der Zwischenraum strömungstechnisch abgeschlossen ist; und
- Fig. 5: eine schematische Schnittdarstellung der Kühlvorrichtung gemäß Fig. 2;
- Fig. 6a: eine schematische Darstellung der Strömungskanäle, die durch Kühlrippen begrenzt sind;
- Fig. 6b: eine schematische Darstellung der Strömungskanäle, die durch Kühldome, Kühlfinger oder Kühlzapfen begrenzt sind.

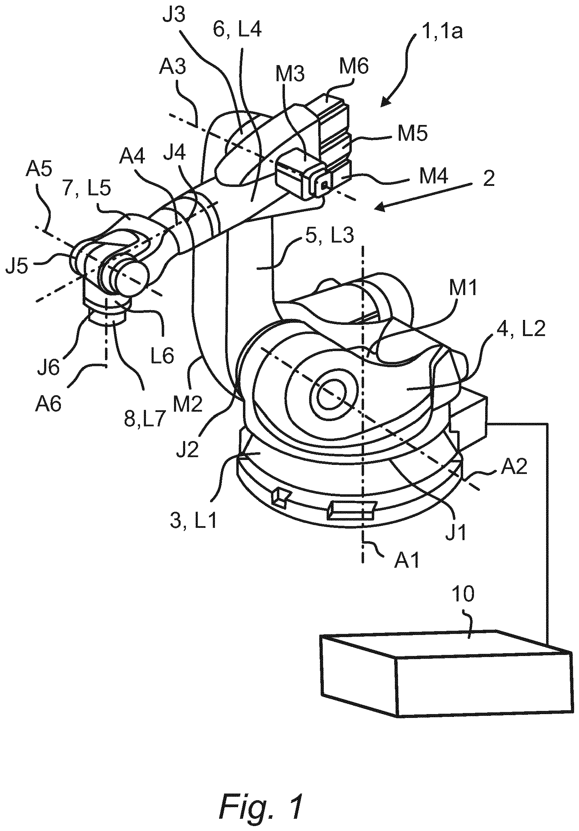

Die Fig. 1 zeigt einen Roboter 1 in der beispielhaften Bauart eines Sechsachs-Knickarmroboters la, der einen Roboterarm 2 und eine Robotersteuervorrichtung 10 aufweist. Der Roboterarm 2 umfasst im Falle des vorliegenden Ausführungsbeispiels mehrere, nacheinander angeordnete und mittels Gelenke J1 bis J6 drehbar miteinander verbundene Glieder L1 bis L7.

Die Robotersteuervorrichtung 10 des Roboters 1 ist ausgebildet bzw. eingerichtet, ein Roboterprogramm auszuführen, durch welches die Gelenke J1 bis J6 des Roboterarms 2 gemäß des Roboterprogramms automatisiert oder in einem Handfahrbetrieb automatisch verstellt bzw. drehbewegt werden können. Dazu ist die Robotersteuervorrichtung 10 mit ansteuerbaren elektrischen Motoren M1 bis M6 des Roboters 1 verbunden, die ausgebildet sind, die Gelenke J1 bis J6 des Roboters 1 zu verstellen.

Bei den Gliedern L1 bis L7 handelt es sich im Falle des vorliegenden Ausführungsbeispiels eines Industrieroboters la um ein Gestell 3 und ein relativ zum Gestell 3 um eine vertikal verlaufende Achse A1 drehbar gelagertes Karussell 4. Weitere Glieder des Roboterarms 2 sind eine Schwinge 5, ein Armausleger 6 und eine vorzugsweise mehrachsige Roboterhand 7 mit einer als Werkzeugflansch 8 ausgeführten Befestigungsvorrichtung zum Befestigen beispielsweise eines Robotergreifers. Die Schwinge 5 ist am unteren Ende, d.h. an dem Gelenk J2 der Schwinge 5 auf dem Karussell 4 um eine vorzugsweise horizontale Drehachse A2 schwenkbar gelagert.

Am oberen Ende der Schwinge 5 ist an dem ersten Gelenk J3 der Schwinge 5 wiederum um eine ebenfalls vorzugsweise horizontale Achse A3 der Armausleger 6 schwenkbar gelagert. Dieser trägt endseitig die Roboterhand 7 mit ihren vorzugsweise drei Drehachsen A4, A5, A6. Die Gelenke J1 bis J6 sind durch jeweils einen der elektrischen Motoren M1 bis M6 über die Robotersteuervorrichtung 10 programmgesteuert antreibbar. Generell kann dazu zwischen jedem der Glieder L1 bis L7 und dem jeweils zugeordneten elektrischen Motoren M1 bis M6 ein Getriebe vorgesehen sein.

Die Robotersteuervorrichtung 10 weist im Falle des vorliegenden Ausführungsbeispiels eine erfindungsgemäße Kühlvorrichtung 11 auf.

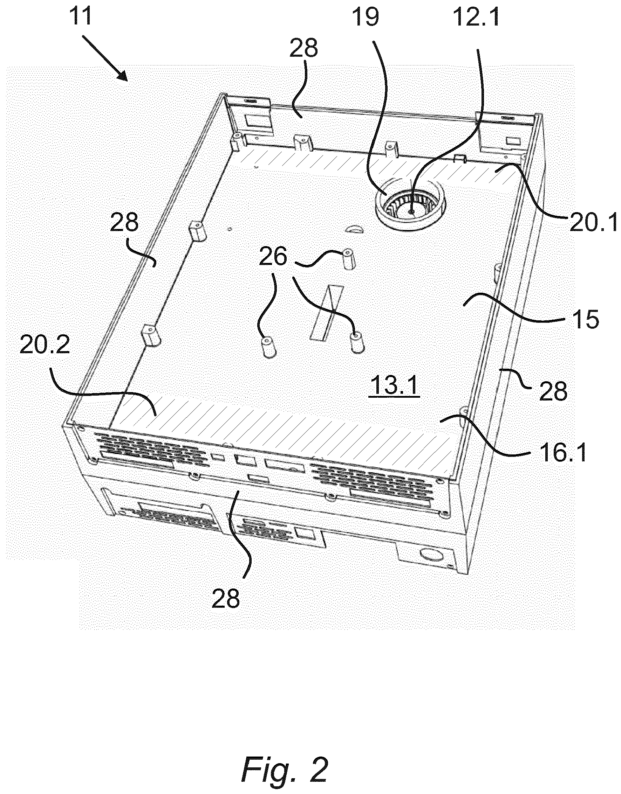

Die Kühlvorrichtung 11 gemäß Fig. 2 bis Fig. 5 ist zum Kühlen von elektrischen Komponenten der Robotersteuervorrichtung 10 ausgebildet. Dazu umfasst die Kühlvorrichtung 11 im Falle des vorliegenden Ausführungsbeispiels einen ersten Lüfter 12.1 und einen zweiten Lüfter 12.2, die beide jeweils eine Kühlluftströmung erzeugen. Die Kühlvorrichtung 11 weist einen ersten Aufnahmeraum 13.1 für erste elektrische Komponenten 14.1 und einen zweiten Aufnahmeraum 13.2 für zweite elektrische Komponenten 14.2 auf. Die Kühlvorrichtung 11 umfasst erfindungsgemäß eine den ersten Aufnahmeraum 13.1 strömungstechnisch von dem zweiten Aufnahmeraum 13.2 separierende Kühlkörperwand 15, welche eine dem ersten Aufnahmeraum 13.1 zugewandte erste Trennwandoberfläche 16.1 und eine gegenüberliegende, einem Zwischenraum 13.3 der Kühlkörperwand 15 zugewandte zweite Trennwandoberfläche 16.2 aufweist, die mit wenigstens einen Strömungskanal 17.1, 17.2 bildenden Kühlwandvorsprüngen 18 versehen ist. Die Kühlkörperwand 15 weist außerdem eine Kühlluft-Durchtrittsöffnung 19 (Fig. 2) auf, die ausgebildet ist, einen von dem ersten Lüfter 12.1 der Kühlvorrichtung 11 geförderten Kühlluftstrom aus dem ersten Aufnahmeraum 13.1 durch die Kühlkörperwand 15 hindurch in den Zwischenraum 13.3 zu fördern.

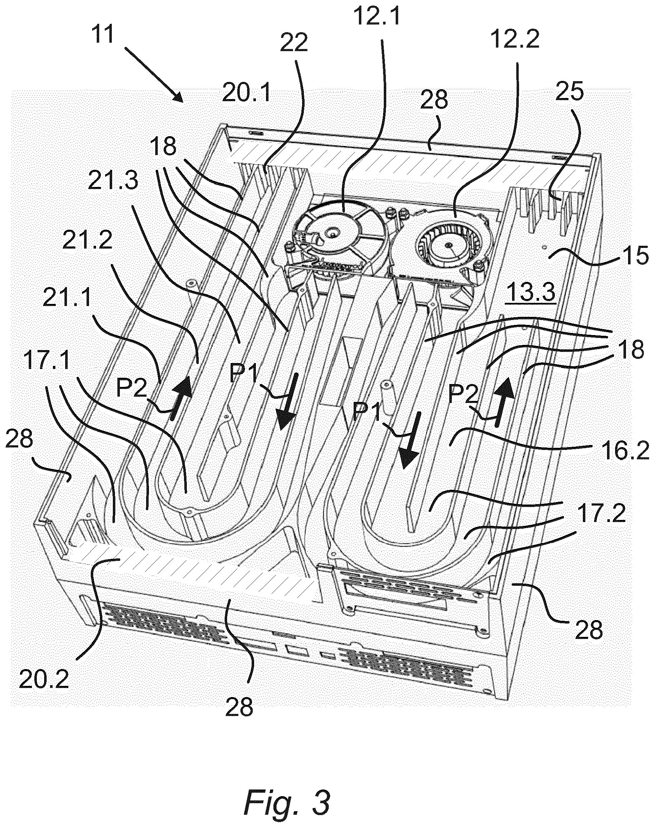

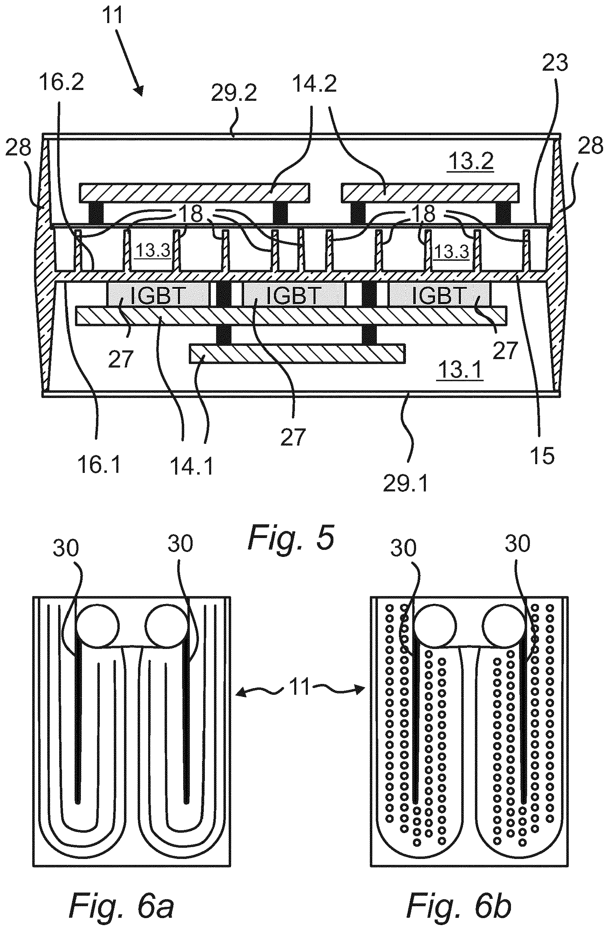

Der erste Lüfter 12.1 ist, wie insbesondere in Fig. 2 und Fig. 3 ersichtlich, an der Kühlluft-Durchtrittsöffnung 19 angeordnet und somit derart ausgebildet, dass der erste Lüfter 12.1 die Kühlluft aus dem ersten Aufnahmeraum 13.1 (Fig. 2) ansaugt und in den Zwischenraum 13.3 (Fig. 3) ausstößt. Der Zwischenraum 13.3 ist zwischen dem ersten Aufnahmeraum 13.1 und dem zweiten Aufnahmeraum 13.2 angeordnet, wie dies insbesondere in der Schnittdarstellung der Fig. 5 zu sehen ist.

Innerhalb des Zwischenraums 13.3 befinden sich die Kühlwandvorsprünge 18, die einteilig mit der Kühlkörperwand 15 ausgebildet sind. Der erste Lüfter 12.1 ist als ein Radiallüfter ausgebildet, der, der derart angeordnet ist, dass der erste Radiallüfter die Kühlluft aus dem ersten Aufnahmeraum 13.1 in axialer Richtung ansaugt und in radialer Richtung in den Zwischenraum 13.3 ausstößt.

Wie insbesondere in Fig. 2 und Fig. 3 ersichtlich ist, ist die Kühlluft-Durchtrittsöffnung 19 im Bereich eines ersten Endabschnitts 20.1 der Kühlkörperwand 15 angeordnet. Die Kühlwandvorsprünge 18 bilden wenigstens einen, im Falle des vorliegenden Ausführungsbeispiels drei erste Strömungskanäle 21.1, 21.2 und 21.3, die von der Durchtrittsöffnung 19 ausgehende, zu einen dem ersten Endabschnitt 20.1 der Kühlkörperwand 15 gegenüberliegenden zweiten Endabschnitt 20.2 der Kühlkörperwand 15 hinführende (Pfeilrichtung P1) erste Hinströmungskanalabschnitte und von dem zweiten Endabschnitt 20.2 der Kühlkörperwand 15 ausgehende, zu dem ersten Endabschnitt 20.1 der Kühlkörperwand 15 zurückführende (Pfeilrichtung P2) erste Rückströmungskanalabschnitte aufweist, wobei an dem ersten Endabschnitt 20.1 eine erste Ausblasöffnung 22 angeordnet ist, über welche die Kühlluft anschließend aus dem Zwischenraum 13.3 bzw. aus den ersten Strömungskanälen 21.1, 21.2 und 21.3 austritt.

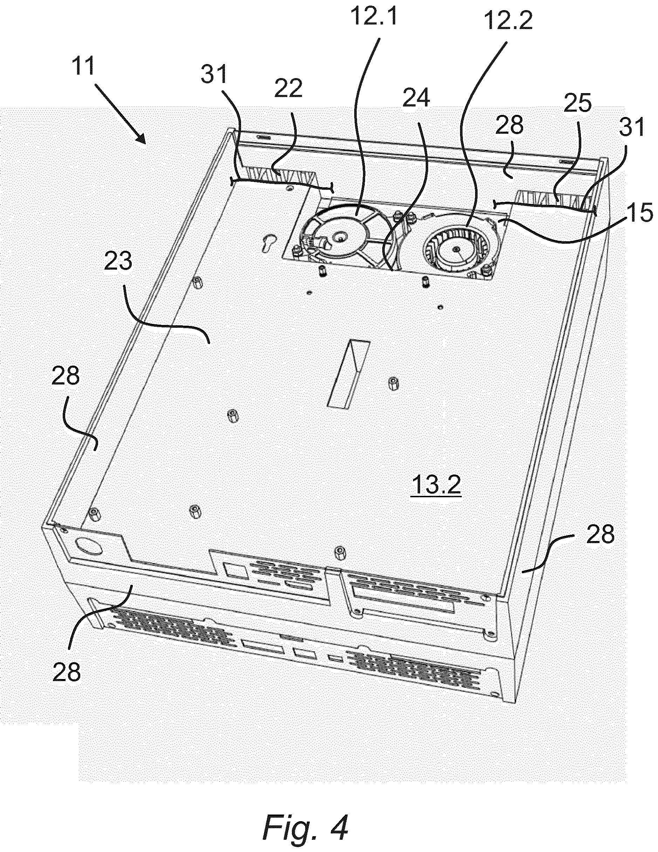

Die Fig. 4 zeigt die Kühlvorrichtung 11 gemäß Fig. 3, allerdings im Unterschied zu Fig. 2 mit einem ersten Deckel 23, der mit der Kühlkörperwand 15 verbunden ist, insbesondere an der Kühlkörperwand 15 mittels Handwerkzeug lösbar angeschraubt ist. Der erste Deckel 23 ist auf der Seite der zweiten Trennwandoberfläche 16.2 der Kühlkörperwand 15 angeordnet und ausgebildet, die die Strömungskanäle 21.1, 21.2 und 21.3 bildenden Kühlwandvorsprüngen 18 zu überdecken, derart, dass die Strömungskanäle 21.1, 21.2 und 21.3 sowohl von der zweiten Trennwandoberfläche 16.2, als auch von den Kühlwandvorsprüngen 18 und dem ersten Deckel 23 strömungstechnisch begrenzend eingefasst ist, wie dies auch in der Schnittdarstellung der Fig. 5 zu sehen ist.

Der erste Deckel 23 weist eine im Falle des vorliegenden Ausführungsbeispiels randoffene Aussparung 24 auf, die ausgebildet ist, einen von dem zweiten Lüfter 12.2 der Kühlvorrichtung 11 geförderten Kühlluftstrom aus dem zweiten Aufnahmeraum 13.2 über den ersten Deckel 23 hinweg in den Zwischenraum 13.3 zu fördern. Im Falle des vorliegenden Ausführungsbeispiels ist die Aussparung 24 im ersten Deckel 23 randoffen ausgebildet, rechteckig geformt und so groß bemessen, dass er einen Montagezugriff sowohl auf den ersten Lüfter 12.1, als auch auf den zweiten Lüfter 12.2 zulässt. In einer alternativen, nicht dargestellten Variante kann die Aussparung 24 aber beispielsweise auch nicht randoffen, d.h. mit geschlossener Randkontur in dem ersten Deckel 23 ausgebildet sein; die Aussparung 24 kann alternativ oder ergänzend zu einer Rechteckform auch kreisförmig ausgebildet sein; und die Aussparung 24 kann so klein (im Durchmesser) ausgeführt sein, dass lediglich der zweite Lüfter 12.2 bzw. dessen Ansaugöffnung ausgespart ist.

Der erste Deckel 23 ist in Fig. 4 mit zeichnerisch abgeschnitten Bruchlinien 31 dargestellt, so dass die erste Ausblasöffnung 22 und die zweite Ausblasöffnung 25 trotz geschlossenem ersten Deckel 23 hier sichtbar sind. Der erste Deckel 23 erstreckt sich jedoch eigentlich bis an die obere Stirnwand der umlaufenden Begrenzungsseitenwand 28, so dass die erste Ausblasöffnung 22 und die zweite Ausblasöffnung 25 an sich von dem ersten Deckel 23 verschlossen sind.

Die Kühlvorrichtung 11 kann demgemäß als einen zweiten Lüfter 12.2 aufweisen, der im Bereich der Aussparung 24 des Deckels 23 angeordnet ist und derart ausgebildet sein kann, dass der zweite Lüfter 12.2 die Kühlluft aus dem zweiten Aufnahmeraum 13.2 ansaugt und in den Zwischenraum 13.3 ausstößt.

Der zweite Lüfter 12.2 kann, wie im Falle des vorliegenden Ausführungsbeispiels dargestellt, als ein zweiter Radiallüfter ausgebildet ist, der derart angeordnet ist, dass der zweite Radiallüfter die Kühlluft aus dem zweiten Aufnahmeraum 13.2 in axialer Richtung ansaugt und in radialer Richtung in den Zwischenraum 13.3 ausstößt.

Die Aussparung 24 des Deckels 23 ist im Falle des vorliegenden Ausführungsbeispiels im Bereich des ersten Endabschnitts 20.1 der Kühlkörperwand 15 angeordnet, die Kühlwandvorsprünge 18 bilden wenigstens einen zweiten Strömungskanal, der einen von der Aussparung 24 des ersten Deckels 23 ausgehenden, zu einen dem ersten Endabschnitt 20.1 der Kühlkörperwand 15 gegenüberliegenden zweiten Endabschnitt 20.2 der Kühlkörperwand 15 hinführenden zweiten Hinströmungskanalabschnitt und einen von dem zweiten Endabschnitt 20.2 der Kühlkörperwand 15 ausgehenden, zu dem ersten Endabschnitt 20.1 der Kühlkörperwand 15 zurückführenden zweiten Rückströmungskanalabschnitt aufweist, an welchem ersten Endabschnitt 20.1 eine zweite Ausblasöffnung 25 angeordnet ist, über welche die Kühlluft aus dem Zwischenraum 13.3 austritt.

Die dem ersten Aufnahmeraum 13.1 zugewandte erste Trennwandoberfläche 16.1 der Kühlkörperwand 15 weist Befestigungsdome 26 auf, die zur Befestigung wenigstens einer elektrischen Komponente 14.1 ausgebildet sind, welche Komponente 14.1 zumindest eine Leistungshalbleiterbauelement 27 aufweist, wobei die Befestigungsdome 26 derart ausgebildet sind, dass im Befestigten Zustand der elektrischen Komponente 14.1 das mindestens eine Leistungshalbleiterbauelement 27 Wärme übertragend an der ersten Trennwandoberfläche 16.1 der Kühlkörperwand 15 anliegt, wie dies insbesondere in Fig. 5 dargestellt ist.

Im Falle des vorliegenden Ausführungsbeispiels ist die Kühlkörperwand 15 als ein einteiliger Druckgusskühlkörper ausgebildet.

Zudem weist im Falle des vorliegenden Ausführungsbeispiels die Kühlkörperwand 15 eine rahmenartig die Kühlkörperwand 15 einfassende, umlaufende Begrenzungsseitenwand 28 auf, die sich zumindest im Wesentlichen senkrecht zur Ebene der Kühlkörperwand 15 erstreckt und die ausgebildet ist, eine Gehäuseaußenwand eines Gehäuses der Robotersteuervorrichtung 10 zu bilden.

Die Kühlkörperwand 15 ist im Falle des vorliegenden Ausführungsbeispiels zusammen mit der, die Gehäuseaußenwand des Gehäuses der Robotersteuervorrichtung 10 bildenden, umlaufenden Begrenzungsseitenwand 28 als ein einteiliger Druckgusskühlkörper ausgebildet.

Die umlaufende Begrenzungsseitenwand 28 der Kühlkörperwand 15 kann demgemäß vier Seitenwände eines Gehäuses der Robotersteuervorrichtung 10 bilden. Darüber hinaus können die verbleibenden zwei Seiten des Gehäuses, die insbesondere eine Vorderseite und eine Rückseite des Gehäuses bilden, durch jeweils einem separaten Gehäusedeckel 29.1, 29.2 verschlossen sein.

Die Fig. 6a zeigt eine erste allgemeine Ausführungsform von Kühlwandvorsprüngen, die als flächige, sich senkrecht von der Kühlkörperwand erhebenden, d.h. vorspringenden Kühlrippen gebildet werden. Die Kühlrippen bilden dabei zusätzliche Kanalwände der Strömungskanäle. Die Kühlrippen sind im Falle des vorliegenden Ausführungsbeispiels der Fig. 6a bogenförmig bzw. U-förmig um eine mittlere Zwischenwand 30 herumgeführt.

Die Fig. 6b zeigt eine zweite allgemeine Ausführungsform, bei der die Kühlwandvorsprünge lediglich von einer Mehrzahl von sich senkrecht von der Kühlkörperwand erhebenden, d.h. vorspringenden und voneinander beabstandeten diskreten Kühldomen, Kühlfingern oder Kühlzapfen gebildet werden, die in der Fig. 6b in der Draufsicht als Kreise dargestellt sind.

Die Kühlwandvorsprünge beider Ausführungsformen können an der Kühlkörperwand derart angeordnet sein, dass jeweils zwei benachbarte Kühlrippen oder jeweils zwei benachbarte Reihen von Kühldomen, Kühlfingern oder Kühlzapfen einen Strömungskanal für Luft bilden. Diese müssen jedoch, wie insbesondere in Fig. 6b ersichtlich nicht durchgängig geschlossen sein. Minimal erforderlich ist lediglich eine mittlere Zwischenwand 30, die den Hinströmungskanalabschnitt eindeutig von dem Rückströmungskanal strömungstechnisch trennt. Die voneinander beabstandeten Kühldome, Kühlfinger oder Kühlzapfen müssen demgemäß beispielsweise nicht wie in Fig. 6b dargestellt in Reihen angeordnet sein, sondern sie können in beliebigen Mustern oder auch ungeordnet verteilt angeordnet sein.

## Patentansprüche

1. Kühlvorrichtung zum Kühlen von elektrischen Komponenten einer Robotersteuervorrichtung (10) mittels einer durch einen Lüfter (12.1, 12.2) erzeugten Kühlluftströmung, aufweisend einen ersten Aufnahmeraum (13.1) für erste elektrische Komponenten (14.1), einen zweiten Aufnahmeraum (13.2) für zweite elektrische Komponenten (14.2) und eine den ersten Aufnahmeraum (13.1) strömungstechnisch von dem zweiten Aufnahmeraum (13.2) separierende Kühlkörperwand (15), welche eine dem ersten Aufnahmeraum (13.1) zugewandte erste Trennwandoberfläche (16.1) und eine gegenüberliegende, einem Zwischenraum (13.3) der Kühlkörperwand (15) zugewandte zweite Trennwandoberfläche (16.2) aufweist, die mit wenigstens einen Strömungskanal bildenden Kühlwandvorsprüngen (18) versehen ist, und welche Kühlkörperwand (15) eine Kühlluft-Durchtrittsöffnung (19) aufweist, die ausgebildet ist, einen von wenigstens einem Lüfter (12.1, 12.2) der Kühlvorrichtung (11) geförderten Kühlluftstrom aus dem ersten Aufnahmeraum (13.1) durch die Kühlkörperwand (15) hindurch in den Zwischenraum (13.3) zu fördern, **dadurch gekennzeichnet, dass** die Kühlluft-Durchtrittsöffnung (19) im Bereich eines ersten Endabschnitts (20.1) der Kühlkörperwand (15) angeordnet ist, die Kühlwandvorsprünge (18) wenigstens einen ersten Strömungskanal (21.1, 21.2, 21.3) bilden, der einen von der Durchtrittsöffnung (19) ausgehenden, zu einen dem ersten Endabschnitt (20.1) der Kühlkörperwand (15) gegenüberliegenden zweiten Endabschnitt (20.2) der Kühlkörperwand (15) hinführenden ersten Hinströmungskanalabschnitt und einen von dem zweiten Endabschnitt (20.2) der Kühlkörperwand (15) ausgehenden, zu dem ersten Endabschnitt (20.1) der Kühlkörperwand (15) zurückführenden ersten Rückströmungskanalabschnitt aufweist, an welchem ersten Endabschnitt (20.1) eine erste Ausblasöffnung (22) angeordnet ist, über welche die Kühlluft aus dem Zwischenraum (13.3) austritt.

2. Kühlvorrichtung nach Anspruch 1, **dadurch gekennzeichnet, dass** die Kühlvorrichtung (11) einen ersten Lüfter (12.1) aufweist, der an der Kühlluft-Durchtrittsöffnung (19) angeordnet ist und derart ausgebildet ist, dass der erste Lüfter (12.1) die Kühlluft aus dem ersten Aufnahmeraum (13.1) ansaugt und in den Zwischenraum (13.3) ausstößt.

3. Kühlvorrichtung nach Anspruch 2, **dadurch gekennzeichnet, dass** der erste Lüfter (12.1) als ein erster Radiallüfter ausgebildet ist, der derart angeordnet ist, dass der erste Radiallüfter die Kühlluft aus dem ersten Aufnahmeraum (13.1) in axialer Richtung ansaugt und in radialer Richtung in den Zwischenraum (13.3) ausstößt.

4. Kühlvorrichtung nach einem der Ansprüche 1 bis 3, **gekennzeichnet durch** einen mit der Kühlkörperwand (15) verbundenen, auf der Seite der zweiten Trennwandoberfläche (16.2) der Kühlkörperwand (15) angeordneten ersten Deckel (23), der ausgebildet ist, die den wenigstens einen Strömungskanal (21.1, 21.2, 21.3) bildenden Kühlwandvorsprünge (18) zu überdecken, derart, dass der wenigstens eine Strömungskanal (21.1, 21.2, 21.3) sowohl von der zweiten Trennwandoberfläche (16.2), als auch von den Kühlwandvorsprüngen (18) und dem ersten Deckel (23) strömungstechnisch begrenzend eingefasst ist.

5. Kühlvorrichtung nach Anspruch 4, **dadurch gekennzeichnet, dass** der erste Deckel (23) eine Aussparung (24) aufweist, die ausgebildet ist, einen von wenigstens einem Lüfter (12.1, 12.2) der Kühlvorrichtung (11) geförderten Kühlluftstrom aus dem zweiten Aufnahmeraum (13.2) über den ersten Deckel (23) hinweg in den Zwischenraum (13.3) zu fördern.

6. Kühlvorrichtung nach Anspruch 5, **dadurch gekennzeichnet, dass** die Kühlvorrichtung (11) einen zweiten Lüfter (12.2) aufweist, der im Bereich der Aussparung (24) des ersten Deckels (23) angeordnet ist und derart ausgebildet ist, dass der zweite Lüfter (12.2) die Kühlluft aus dem zweiten Aufnahmeraum (13.2) ansaugt und in den Zwischenraum (13.3) ausstößt.

7. Kühlvorrichtung nach Anspruch 6, **dadurch gekennzeichnet, dass** der zweite Lüfter (12.2) als ein zweiter Radiallüfter ausgebildet ist, der derart angeordnet ist, dass der zweite Radiallüfter die Kühlluft aus dem zweiten Aufnahmeraum (13.2) in axialer Richtung ansaugt und in radialer Richtung in den Zwischenraum (13.3) ausstößt.

8. Kühlvorrichtung nach einem der Ansprüche 5 bis 7, **dadurch gekennzeichnet, dass** die Aussparung (24) des ersten Deckels (23) im Bereich des ersten Endabschnitts (20.1) der Kühlkörperwand (15) angeordnet ist, die Kühlwandvorsprünge (18) wenigstens einen zweiten Strömungskanal bilden, der einen von der Aussparung (24) des ersten Deckels (23) ausgehenden, zu einen dem ersten Endabschnitt (20.1) der Kühlkörperwand (15) gegenüberliegenden zweiten Endabschnitt (20.2) der Kühlkörperwand (15) hinführenden zweiten Hinströmungskanalabschnitt und einen von dem zweiten Endabschnitt (20.2) der Kühlkörperwand (15) ausgehenden, zu dem ersten Endabschnitt (20.1) der Kühlkörperwand (15) zurückführenden zweiten Rückströmungskanalabschnitt aufweist, an welchem ersten Endabschnitt (20.1) eine zweite Ausblasöffnung (25) angeordnet ist, über welche die Kühlluft aus dem Zwischenraum (13.3) austritt.

9. Kühlvorrichtung nach einem der Ansprüche 1 bis 8, **dadurch gekennzeichnet, dass** die dem ersten Aufnahmeraum (13.1) zugewandte erste Trennwandoberfläche (16.1) der Kühlkörperwand (15) Befestigungsdome (26) aufweist, die zur Befestigung wenigstens einer elektrischen Komponente (14.1) ausgebildet sind, welche elektrische Komponente (14.1) zumindest ein Leistungshalbleiterbauelement (27) aufweist, wobei die Befestigungsdome (26) derart ausgebildet sind, dass im befestigten Zustand der elektrischen Komponente (14.1) das mindestens eine Leistungshalbleiterbauelement (27) Wärme übertragend an der ersten Trennwandoberfläche (16.1) der Kühlkörperwand (15) anliegt.

10. Kühlvorrichtung nach einem der Ansprüche 1 bis 9, **dadurch gekennzeichnet, dass** die Kühlkörperwand (15) als ein einteiliger Druckgusskühlkörper ausgebildet ist.

11. Kühlvorrichtung nach einem der Ansprüche 1 bis 10, **dadurch gekennzeichnet, dass** die Kühlkörperwand (15) eine rahmenartig die Kühlkörperwand (15) einfassende, umlaufende Begrenzungsseitenwand (28) aufweist, die sich zumindest im Wesentlichen senkrecht zur Ebene der Kühlkörperwand (15) erstreckt und die ausgebildet ist, eine Gehäuseaußenwand eines Gehäuses einer Robotersteuervorrichtung (10) zu bilden.

12. Kühlvorrichtung nach Anspruch 11, **dadurch gekennzeichnet, dass** die Kühlkörperwand (15) zusammen mit der eine Gehäuseaußenwand eines Gehäuses einer Robotersteuervorrichtung (10) bildenden, umlaufenden Begrenzungsseitenwand (28) als ein einteiliger Druckgusskühlkörper ausgebildet ist.

13. Robotersteuervorrichtung, aufweisend eine Kühlvorrichtung (11) nach einem der Ansprüche 1 bis 12.

## Claims

1. Cooling device for cooling electrical components of a robot control device (10) by means of a cooling air flow generated by a fan (12.1, 12.2), having a first receiving space (13.1) for first electrical components (14.1), a second receiving space (13.2) for second electrical components (14.2) and a heat sink wall (15) which separates the first receiving space (13.1) from the second receiving space (13.2) in terms of flow and which has a first partition surface (16.1) facing the first receiving space (13.1) and an opposite, an interstice (13.3) of the heat sink wall (15) facing a second partition wall surface (16.2) which is provided with at least one cooling wall projections (18) forming a flow channel, and which heat sink wall (15) has a cooling air passage opening (19) which is formed, a cooling air flow conveyed by at least one fan (12.1, 12.2) of the cooling device (11) from the first receiving space (1 3.1) through the heat sink wall (15) into the interstice (13.3), **characterized in that** the cooling air passage opening (19) is arranged in the area of a first end section (20.1) of the heat sink wall (15), the cooling wall projections (18) form at least one first flow channel (21.1, 21.2, 21.3) which has a first inflow channel section starting from the passage opening (19) and leading to a second end section (20.2) of the cooling body wall (15) opposite the first end section (20.1) of the cooling body wall (15) and has a first return flow channel section starting from the second end section (20.2) of the heat sink wall (15) and leading back to the first end section (20.1) of the heat sink wall (15), on which first end section (20.1) a first blow-out opening (22) is arranged which the cooling air exits from the interstice (13.3).

2. Cooling device according to claim 1, **characterized in that** the cooling device (11) has a first fan (12.1) which is arranged on the cooling air passage opening (19) and is designed such that the first fan (12.1 ) draws in the cooling air from the first receiving space (13.1) and ejects it into the interstice(13.3).

3. Cooling device according to claim 2, **characterized in that** the first fan (12.1) is designed as a first radial fan which is arranged such that the first radial fan sucks in the cooling air from the first receiving space (13.1) in the axial direction and ejects in the radial direction into the interstice (13.3).

4. Cooling device according to one of claims 1 to 3, **characterized by** a first cover (23) which is connected to the heat sink wall (15) and is arranged on the side of the second partition wall surface (16.2) of the heat sink wall (15) and which is formed which to cover the at least one flow channel (21.1, 21.2, 21.3) forming cooling wall projections (18) in such a way that the at least one flow channel (21.1, 21.2, 21.3) both from the second partition wall surface (16.2) and from the cooling wall projections (18) and the first cover (23) is framed in a flow-limiting manner.

5. Cooling device according to claim 4, **characterized in that** the first cover (23) has a recess (24) which is designed to take a cooling air flow conveyed by at least one fan (12.1, 12.2) of the cooling device (11) from the second receiving to promote space (13.2) over the first cover (23) into the interstice (13.3).

6. Cooling device according to claim 5, **characterized in that** the cooling device (11) has a second fan (12.2) which is arranged in the region of the recess (24) of the first cover (23) and is designed such that the second Fan (12.2) sucks the cooling air from the second receiving space (13.2) and ejects it into the interstice (13.3) .

7. Cooling device according to claim 6, **characterized in that** the second fan (12.2) is designed as a second radial fan which is arranged such that the second radial fan sucks the cooling air from the second receiving space (13.2) in the axial direction and in the ejects it in the radial direction in the interstice (13.3).

8. Cooling device according to one of claims 5 to 7, **characterized in that** the recess (24) of the first cover (23) is arranged in the region of the first end section (20.1) of the cooling body wall (15), the cooling wall projections (18) form at least one second flow channel , the one from the recess (24) of the first cover (23) leading to a second end section (20.2) of the cooling body wall (15) opposite the first end section (20.1) of the cooling body wall (15) and one from the second end section (20.2) of the heat sink wall (15) outgoing to the first end section (20.1) of the heat sink wall (15) has a second return flow channel section, at which first end section (20.1) a second blow-out opening (25) is arranged, through which the cooling air from the interstice (13.3) emerges.

9. Cooling device according to one of claims 1 to 8, **characterized in that** the first partition wall surface (16.1) of the heat sink wall (15) facing the first receiving space (13.1) has fastening domes (26) which are designed for fastening at least one electrical component (14.1) which electrical component (14.1) has at least one power semiconductor component (27), the fastening domes (26) being designed in such a way that when the electrical component (14.1) is fastened, the at least one power semiconductor component (27) transfers heat to the first partition wall surface ( 16.1) rests against the heat sink wall (15).

10. Cooling device according to one of Claims 1 to 9, **characterized in that** the cooling body wall (15) is designed as a one-piece die-cast cooling body.

11. Cooling device according to one of claims 1 to 10, **characterized in that** the cooling body wall (15) has a peripheral limiting side wall (28) which surrounds the cooling body wall (15) in a frame-like manner, which extends at least substantially perpendicular to the plane of the cooling body wall (15) and which is designed to form an outer housing wall of a housing of a robot control device (10).

12. Cooling device according to claim 11, **characterized in that** the cooling body wall (15) is designed as a one-piece die-cast cooling body together with the circumferential limiting side wall (28) forming a housing outer wall of a housing of a robot control device (10).

13. Robot control device, having a cooling device (11) according to one of Claims 1 to 12.

## Revendications

1. Dispositif de refroidissement pour refroidir des composants électriques d'un dispositif de commande de robot (10) au moyen d'un flux d'air de refroidissement généré par un ventilateur (12.1, 12.2), comportant un premier espace de réception (13.1) pour des premiers composants électriques (14.1), un deuxième espace de réception (13.2) pour les deuxièmes composants électriques (14.2) et une paroi de dissipation thermique (15) qui sépare le premier espace de réception (13.1) du deuxième espace de réception (13.2) en termes d'écoulement et qui a une première surface de séparation ( 16.1) en regard du premier espace de réception (13.1) et en regard, un interstice (13.3) de la paroi de dissipation thermique (15) en regard d'une seconde surface de paroi de séparation (16.2) qui est munie d'au moins une paroi de refroidissement en saillie (18 ) formant un canal d'écoulement, et dont la paroi de dissipation thermique (15) présente une ouverture de passage d'air de refroidissement (19) qui est formée, un flux d'air de refroidissement véhiculé par au moins un ventilateur (12.1, 12.2) du dispositif de refroidissement (11) depuis le premier espace de réception (1 3.1) à travers la paroi du dissipateur thermique (15) dans l'interstice (13.3), caracteriz en ce que l'ouverture de passage d'air de refroidissement (19) est disposée dans la zone d'un premier tronçon d'extrémité (20.1) de la paroi de dissipation thermique (15), les saillies de paroi de refroidissement (18) forment au moins un premier canal d'écoulement (21.1, 21.2, 21.3) qui présente une première section de canal d'admission partant de l'ouverture de passage (19) et menant à une deuxième section d'extrémité (20.2) de la paroi du corps de refroidissement (15) opposée à la première section d'extrémité (20.1) de la paroi du corps de refroidissement (15) et comporte une première section de canal de retour partant de la seconde section d'extrémité (20.2) de la paroi de dissipateur thermique (15) et remontant jusqu'à la première section d'extrémité (20.1) de la paroi de dissipateur de chaleur (15), sur laquelle première section d'extrémité (20.1) une première ouverture de soufflage (22) est disposée par laquelle l'air de refroidissement sort de l'interstice (13.3).

2. Dispositif de refroidissement selon la revendication 1, **caractérisé en ce que** le dispositif de refroidissement (11) comporte un premier ventilateur (12.1) qui est disposé sur l'ouverture de passage d'air de refroidissement (19) et est conçu de telle sorte que le premier ventilateur (12.1) aspire le refroidissement l'air du premier espace de réception (13.1) et l'éjecte dans l'interstice (13.3) .

3. Dispositif de refroidissement selon la revendication 2, **caractérisé en ce que** le premier ventilateur (12.1) est conçu comme un premier ventilateur radial qui est agencé de telle sorte que le premier ventilateur radial aspire l'air de refroidissement du premier espace de réception (13.1) dans le direction et éjecte dans la direction radiale dans l'interstice (13.3).

4. Dispositif de refroidissement selon l'une des revendications 1 à 3, **caractérisé par** un premier couvercle (23) qui est relié à la paroi du dissipateur de chaleur (15) et est disposé du côté de la deuxième surface de paroi de séparation (16.2) du radiateur paroi d'évier (15) et qui est formée pour couvrir le au moins un canal d'écoulement (21.1, 21.2, 21.3) formant des saillies de paroi de refroidissement (18) de telle sorte que le au moins un canal d'écoulement (21.1, 21.2, 21.3) à la fois à partir de la seconde surface de paroi de séparation (16.2) et à partir des saillies de paroi de refroidissement (18) et le premier couvercle (23) est encadré de manière à limiter l'écoulement.

5. Dispositif de refroidissement selon la revendication 4, **caractérisé en ce que** le premier couvercle (23) présente un évidement (24) qui est destiné à recevoir un flux d'air de refroidissement véhiculé par au moins un ventilateur (12.1, 12.2) du dispositif de refroidissement (11) de le second recevant pour favoriser l'espace (13.2) sur le premier couvercle (23) dans l'interstice (13.3) .

6. Dispositif de refroidissement selon la revendication 5, **caractérisé en ce que** le dispositif de refroidissement (11) comporte un deuxième ventilateur (12.2) qui est disposé dans la zone de l'évidement (24) du premier couvercle (23) et est conçu de telle sorte que le deuxième ventilateur (12.2) aspire l'air de refroidissement du deuxième espace de réception (13.2) et l'éjecte dans l'interstice (13.3).

7. Dispositif de refroidissement selon la revendication 6, **caractérisé en ce que** le deuxième ventilateur (12.2) est conçu comme un deuxième ventilateur radial qui est agencé de telle sorte que le deuxième ventilateur radial aspire l'air de refroidissement du deuxième espace de réception (13.2) dans la direction axiale et en l'éjecte dans la direction radiale dans l'interstice (13.3).

8. Dispositif de refroidissement selon l'une des revendications 5 à 7, **caractérisé en ce que** l'évidement (24) du premier couvercle (23) est disposé dans la zone du premier tronçon d'extrémité (20.1) de la paroi du corps de refroidissement (15), le des saillies de paroi (18) forment au moins un deuxième canal d'écoulement, celui de l'évidement (24) du premier couvercle (23) menant à une deuxième section d'extrémité (20.2) de la paroi du corps de refroidissement (15) opposée au premier section d'extrémité (20.1) de la paroi du corps de refroidissement (15) et une de la deuxième section d'extrémité (20.2) de la paroi de dissipateur thermique (15) sortant vers la première section d'extrémité (20.1) de la paroi de dissipateur de chaleur (15) a un deuxième section de canal d'écoulement de retour, au niveau de laquelle la première section d'extrémité (20.1) est disposée une deuxième ouverture de soufflage (25) à travers laquelle l'air de refroidissement de l'interstice (13.3) sort.

9. Dispositif de refroidissement selon l'une des revendications 1 à 8, **caractérisé en ce que** la première surface de paroi de séparation (16.1) de la paroi du dissipateur de chaleur (15) tournée vers le premier espace de réception (13.1) présente des dômes de fixation (26) qui sont conçus pour fixation d'au moins un composant électrique (14.1) lequel composant électrique (14.1) présente au moins un composant semi-conducteur de puissance (27), les calottes de fixation (26) étant conçues de telle sorte que lors de la fixation du composant électrique (14.1) , le au moins un composant semi-conducteur de puissance (27) transfère de la chaleur à la première surface de paroi de séparation (16.1) repose contre la paroi de dissipation thermique (15).

10. Dispositif de refroidissement selon l'une des revendications 1 à 9, **caractérisé en ce que** la paroi du corps de refroidissement (15) est réalisée sous la forme d'un corps de refroidissement monobloc moulé sous pression.

11. Dispositif de refroidissement selon l'une des revendications 1 à 10, **caractérisé en ce que** la paroi du corps de refroidissement (15) présente une paroi latérale de limitation périphérique (28) qui entoure la paroi du corps de refroidissement (15) à la manière d'un cadre, qui s'étend au moins sensiblement perpendiculaire au plan de la paroi du corps de refroidissement (15) et qui est conçu pour former une paroi de boîtier externe d'un boîtier d'un dispositif de commande de robot (10).

12. Dispositif de refroidissement selon la revendication 11, **caractérisé en ce que** la paroi du corps de refroidissement (15) est conçue comme un corps de refroidissement moulé sous pression d'une seule pièce avec la paroi latérale de limitation circonférentielle (28) formant une paroi extérieure de boîtier d'un boîtier d'un robot dispositif de commande (10).

13. Dispositif de commande de robot comportant un dispositif de refroidissement (11) selon l'une des revendications 1 à 12.
